# EUROPÄISCHE PATENTANMELDUNG

(11) **EP 0 542 228 A1**
(43) Veröffentlichungstag der Anmeldung: **19.05.1993**
(21) Anmeldenummer: 92119289.4
(22) Anmeldetag: 11.11.1992
(51) Int. Cl.: G03F 7/42

(54) **Entschichtungsmittel**

(30) Priorität: 11.11.1991 DE 4137027
(71) Anmelder: Stubinitzky, Heinz-Günter, D-83658 Lenggries (DE)
(72) Erfinder: Stubinitzky, Heinz-Günter, D-83658 Lenggries (DE)

(57) **Zusammenfassung**

Entschichtungsmittel zum Entfernen hochvernetzter Polyvinylalkoholschichten von Trägeroberflächen, enthaltend Periodsäure und/oder Orthoperiodsäure und mindestens ein Alkalimetallalkansulfonat in einer Konzentration von 1,5 bis 5 Gew.-%, bezogen auf Orthoperiodsäure, in wässriger Lösung. Das Entschichtungsmittel ist in einer Konzentration von bis zu 30 Gew.-% Periodsäuren lagerfähig und transportfähig. Für den Gebrauch wird das Konzentrat im Verhältnis 1:30 bis 1:50 mit Wasser verdünnt.

## Beschreibung

Die Erfindung betrifft ein Mittel zum Entfernen von vernetztem Polyvinylalkohol, speziell "unlöslich" gemachtem Polyvinylalkohol von Trägeroberflächen, speziell von Druckformträgeroberflächen. Dabei ist der Begriff des Druckformträgers in seinem weitesten Sinne zu verstehen und soll beispielsweise Trägerplatten, insbesondere aus Aluminium, Siebdruckgewebe, Seidenrastergewebe ebenso wie Sonderträger, beispielsweise Steinplatten, umfassen.

Trägeroberflächen im hier benutzten Sinne können jedoch prinzipiell auch Oberflächen anderer Werkstoffe sein, beispielsweise Oberflächen von Werkstücken, die mit solchen Polyvinylalkohol enthaltenden Photolackdruckformen bedruckt worden sind.

Die Verwendung von wässrigen, Periodationen enthaltenden Lösungen zum Entfernen von Photolackschichten von Trägeroberflächen ist aus der deutschen Auslegeschrift DE 22 26 164 B2 bekannt. Diese Periodatlösungen können zusätzlich Bleichmittel (auf der Basis von Natriumdichlorisocyanurat) und/oder Komplexbildner und/oder Desensibilisierungsmittel enthalten.

Nachteilig an diesen bekannten Entschichtungsmitteln ist, daß sie nur in geringer Konzentration beschränkt lagerfähig sind. Auch können mit diesem bekannten Entschichtungsmittel die Druckformträger in der Regel nicht so weit entschichtet und gereinigt werden, daß sie ohne weitere Nachbehandlung wiederverwendbar sind.

Der Erfindung liegt die Aufgabe zugrunde, ein Entschichtungsmittel der vorstehend beschriebenen Art zu schaffen, das als Konzentrat auch über mehr als ein Jahr ohne Einbuße an Wirksamkeit lagerfähig ist und nach Verdünnung auf Anwendungskonzentration Trägeroberflächen schafft, die nach dem Trocknen unmittelbar wiederverwendbar sind.

Zur Lösung dieser Aufgabe schafft die Erfindung ein Mittel zum Entfernen von vernetztem Polyvinylalkohol in Form von Schichten oder als Bestandteil von Schichten von Trägeroberflächen, insbesondere von Druckformträgeroberflächen, enthaltend Periodsäure und/oder Orthoperiodsäure und mindestens ein Alkalimetallalkansulfonat in einer Menge von 1,5 bis 5 Gew.-%, bezogen auf Orthoperiodsäure in wässriger Lösung. Dabei erfolgt die Einwaage des Periodats vorzugsweise in Form von Orthoperiodsäure.

Das Entschichtungsmittel gemäß der Erfindung kann durch das praktisch vollkommen inerte Verhalten der Alkalimetallalkansulfonate gegenüber den stark oxidierenden Orthoperiodsäuren selbst in Konzentrationen von 20 bis 30 Gew.-% Periodsäuren ohne Einbuße der Wirksamkeit bei Raumtemperatur über mindestens ein Jahr lang gelagert werden. Dabei bewirkt das im Entschichtungsmittel neben den Periodsäuren eingesetzte tensidische Alkalimetallalkansulfonat nicht nur eine den Angriff des Oxidationsmittels erleichternde Vorentfettung der zu entfernenden Polyvinylalkoholschichten, sondern im angegebenen Konzentrationsbereich auch eine Nachreinigung der freigelegten Trägeroberfläche, so daß diese nach einem einfachen Trockungsvorgang unmittelbar wiederverwendbar, insbesondere also wieder mit Photolack beschichtbar, ist.

Die Konzentrate können dann durch Zusatz von Wasser auf Anwendungskonzentration verdünnt werden. In der zum Einsatz gelangenden Verdünnung beträgt die Gesamtkonzentration der Periodsäuren vorzugsweise 0,3 bis 1,0 Gew.-%, insbesondere 0,5 bis 0,8 Gew.-%, bezogen auf die Gesamtmasse des Entschichtungsmittels.

Für die Verdünnung des Entschichtungsmittelkonzentrats kann ohne Nachteil Leitungswasser verwendet werden. Zur Herstellung des Konzentrats wird vorzugsweise jedoch deionisiertes Wasser benutzt, um während der Lagerzeit Fällungsreaktionen und eine Reduktion der Periodationen zu unterdrücken.

Aus dem Stand der Technik ist bekannt, Ethylendiamintetraessigsäure als Komplexbildner zur Stabilisierung der Periodationen in wässriger Lösung einzusetzen. Überraschend ist jedoch, daß eine nur mäßig höhere Konzentration Ethylendiamintetraessigsäure im Entschichtungsmittel, nämlich eine Konzentration im Bereich von 1 bis 5 Gew.-%, bezogen auf Orthoperiodsäure, eine zuverlässige Stabilisierung der Periodationen auch in den Konzentraten bewirkt.

Das Entschichtungsmittel gemäß der Erfindung wird vorzugsweise unter Druck zerstäubend auf die zu behandelnden und zu reinigenden Oberflächen aufgesprüht. Um diese Art der Anwendung zu ermöglichen, enthält das Entschichtungsmittel vorzugsweise einen Entschäumer, und zwar insbesondere Glycerinester von Fettsäuregemischen, und zwar zweckmäßigerweise in einer Konzentration von 1 bis 2,5 Gew.-%, bezogen auf die Gesamtmasse des Entschichtungsmittels.

Speziell dann, wenn das Entschichtungsmittel gemäß der Erfindung auch für die Reinigung gelatinehaltiger Oberflächen eingesetzt werden soll, wie sie beispielsweise im Transferdruckverfahren für den Keramikdruck verwendet werden, enthält das Entschichtungsmittel bei einer Stabilisierung des pH-Wertes auf einen Bereich von 1,5 ein proteolytisches Enzym, insbesondere Pepsin, vorzugsweise in einer Konzentration im Bereich von 3 bis 5 Gew.-%, insbesondere in Verbindung mit einem Ampholyten, vorzugsweise in Verbindung mit einem tensidisch wirkenden Ampholyten ("Ampholyttensid"), und zwar ebenfalls vorzugsweise im Konzentrationsbereich von 3 bis 5 Gew.-% des Ampholyten, bezogen auf Orthoperiodsäure.

### Beispiel:

Bei Raumtemperatur werden 24 Gew.-% Orthoperiodsäure mit technischem Reinheitsgrad und 0,8 Gew.-% Natrium-sek.-C₁₃-₁₇-Alkansulfonat in 10 l deionisiertes Wasser eingerührt und zumindest weitgehend gelöst. Dann werden 0,4 Gew.-% eines im Handel erhältlichen Entschäumers auf der Basis eines Glycerinesters gemischter Fettsäuren und 10 g Ethylendiamintetraessigsäure in die Lösung gegeben.

Die ggf. nach weiterem Rühren erhaltene klare Lösung wird anschließend im Verhältnis 1:40 verdünnt und in einen Druckzerstäuber gefüllt.

Die verdünnte Lösung wird sodann als feiner Sprühnebel auf eine zu reinigende Druckform aufgetragen. Auf der Oberfläche des Trägers, einer Aluminiumfolie ist eine benutzte und nach dem Abdrucken lediglich abgewischte entwickelte Photolack-Druckform auf Polyvinylalkoholbasis aufgebracht.

Das verdünnte Entschichtungsmittel wird so auf die Oberfläche der Druckform aufgesprüht, daß diese flächendeckend satt benetzt ist.

Nach einer Verweilzeit von 30 sec wird die aufoxidierte Photolackschicht mit einem Hochdruckreiniger in wenigen Sekunden von der Trägerfläche abgespült. Als Spülmittel kann dabei sowohl Wasser als auch die verdünnte Entschichterlösung selbst dienen. In diesem Fall kann die Trägeroberfläche noch einmal kurz mit klarem Wasser nachgespült werden.

Die entschichtete Trägeroberfläche wird anschließend getrocknet und erneut mit dem Photolack beschichtet. Die getrocknete neue Photolackschicht haftet fest und ohne Ablösungen auf der Trägeroberfläche.

## Patentansprüche

1. Mittel zum Entfernen von vernetztem Polyvinylalkohol in Form von Schichten oder als Bestandteil von Schichten von Trägeroberflächen, insbesondere von Druckformträgeroberflächen, enthaltend Periodsäure und/oder Orthoperiodsäure und mindestens ein Alkalimetallalkansulfonat in einer Menge von 1,5 bis 5 Gew.-%, bezogen auf Orthoperiodsäure, in wässriger Lösung.

2. Entschichtungsmittel nach Anspruch 1 als lagerfähiges Konzentrat,
**gekennzeichnet** durch
eine Gesamtkonzentration von 20 bis 30 Gew.-% Periodsäure und/oder Orthoperiodsäure, bezogen auf die Gesamtmasse des Beschichtungsmittels.

3. Entschichtungsmittel nach Anspruch 1 in anwendungsgerechter Verdünnung,
**gekennzeichnet** durch
eine Gesamtkonzentration der Periodsäure und/oder Orthoperiodsäure von 0,3 bis 1,0 Gew.-%, bezogen auf die Gesamtmasse des Entschichtungsmittels.

4. Entschichtungsmittel nach einem der Ansprüche 1 bis 3,
**gekennzeichnet** durch
deionisiertes Wasser als wässriges Lösungsmittel.

5. Entschichtungsmittel nach einem der Ansprüche 1 bis 4,
**gekennzeichnet** durch
den Gehalt von zusätzlich 1 bis 5 Gew.-% Ethylendiamintetraessigsäure, bezogen Orthoperiodsäure.

6. Entschichtungsmittel nach einem der Ansprüche 1 bis 5,
**gekennzeichnet** durch
Natrium-sek.-C₁₃-₁₇-alkansulfonate als Alkalimetallsulfonate.

7. Entschichtungsmittel nach einem der Ansprüche 1 bis 6,
**gekennzeichnet** durch
den Gehalt von zusätzlich 1 bis 2,5 Gew.-% Fettsäureglycerinester, bezogen auf die Gesamtmasse des Entschichtungsmittels, als Entschäumer.

8. Entschichtungsmittel nach einem der Ansprüche 1 bis 7,
**gekennzeichnet** durch
den Gehalt von zusätzlich 3 bis 5 Gew.-% eines Ampholyten, insbesondere Ampholyttensids, bezogen auf Orthoperiodsäure.

9. Entschichtungsmittel nach Anspruch 8,
**gekennzeichnet** durch
den Gehalt von zusätzlich 3 bis 5 Gew.-% eines proteolytischen Enzyms, insbesondere Pepsin, bezogen auf Orthoperiodsäure.

10. Verfahren zum Entschichten von Trägeroberflächen von vernetzten Polyvinylalkoholschichten,
dadurch **gekennzeichnet**,
daß ein verdünntes Entschichtungsmittel nach einem der Ansprüche 1 oder 3 bis 9 auf die zu entschichtende Oberfläche feinzerteilt aufgesprüht und nach einer Verweilzeit von weniger als 2 min die aufoxidierte Schicht mit Wasser oder einer wässrigen Behandlungslösung abgespült wird.
